# FASCICULE DE BREVET EUROPEEN

(11) **EP 2 168 242 B1**
(45) Date de publication et mention de la délivrance du brevet: **12.10.2011**
(21) Numéro de dépôt: 08775106.1
(22) Date de dépôt: 15.07.2008
(51) Int. Cl.: H03K 17/76

(54) **DISPOSITIF DE COMMUTATION ACTIF ET CIRCUIT INTÉGRÉ HYPERFREQUENCES COMPORTANT UN TEL DISPOSITIF**
AKTIVES SCHALTBAUELEMENT UND INTEGRIERTE HYPERFREQUENZSCHALTUNG MIT EINEM SOLCHEN BAUELEMENT
ACTIVE SWITCHING DEVICE AND HYPER-FREQUENCY INTEGRATED CIRCUIT INCLUDING SUCH DEVICE

(30) Priorité: 20.07.2007 FR 0705287
(43) Date de publication de la demande: 31.03.2010
(73) Titulaire: THALES, 92200 Neuilly-sur-Seine (FR)
(72) Inventeur: DUEME, Philippe, F-91400 Orsay (FR); AURIC, Claude, F-78117 Chateaufort (FR)
(74) Mandataire: Lucas, Laurent Jacques
(86) Numéro de dépôt international: PCT/EP2008/059249
(87) Numéro de publication internationale: WO 2009/013183

(56) Documents cités:
- EP-A- 0 886 391
- JP-A- 9 232 932
- KOBAYASHI K W ET AL: "A Monolithic HEMT-HBT Direct-Coupled Amplifier with Active Input Matching" IEEE MICROWAVE AND GUIDED WAVE LETTERS, IEEE INC, NEW YORK, US, vol. 6, no. 1, janvier 1996 (1996-01), XP011035023 ISSN: 1051-8207

## Description

L'invention concerne un dispositif de commutation actif adapté en particulier aux circuits intégrés d'émission/réception hyperfréquences des antennes à balayage électronique.

Une antenne à balayage électronique comporte un assemblage de modules actifs disposés côte à côte de façon que toutes les faces de sortie desdits modules soient regroupées au voisinage d'une surface d'émission de l'antenne. Les faces de sortie des modules comportent des moyens de raccordement à des éléments rayonnants élémentaires, placés devant les modules et occupant ladite surface d'émission. Cette dernière est par exemple approximativement circulaire.

Chaque module actif comporte un circuit d'émission réception et en général le circuit de commande de ce dernier.

Un exemple pour un tel circuit est décrit dans le document JP 09 232 932 A.

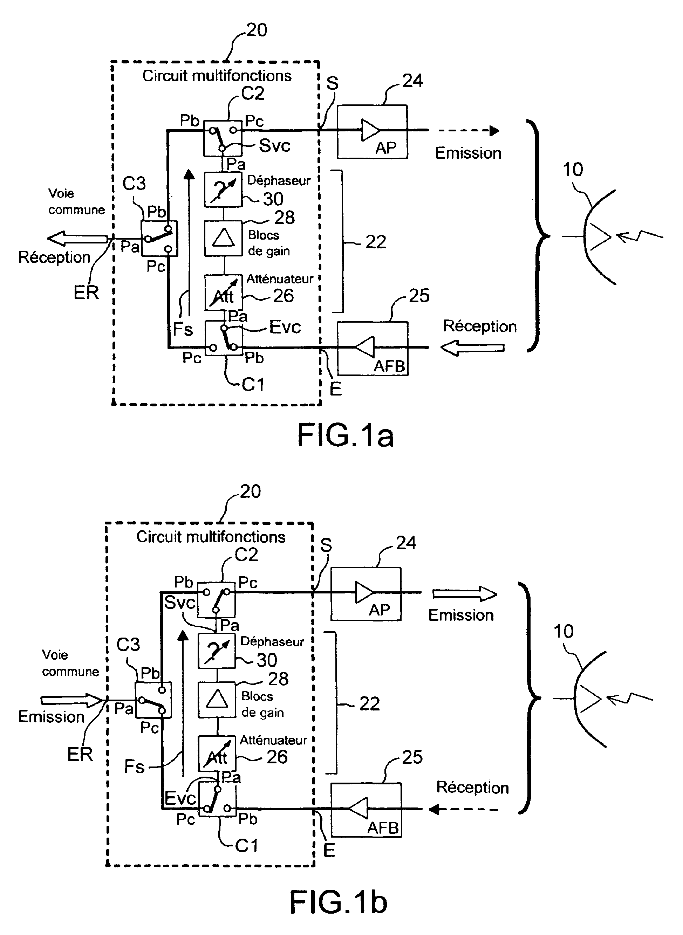

Les figure 1 a et 1 b représentent un schéma synoptique d'un module associé à un élément rayonnant élémentaire d'une antenne à balayage électronique.

La figure 1 a montre le module en configuration de réception d'un signal capté par l'élément rayonnant 10 élémentaire de l'antenne à balayage électronique et la figure 1b le module en configuration d'émission d'un signal par ledit élément rayonnant 10 appliqué à l'entrée du module.

Le module représenté aux figures 1 a et 1b comporte un circuit multifonctions 20 ayant un accès ER bidirectionnel par lequel transitent différemment, soit un signal de réception capté par l'élément rayonnant 10 (figure 1a), soit un signal d'émission à émettre par ledit élément rayonnant (figure 1 b).

Le module comporte un amplificateur de puissance AP 24 connecté par sa sortie à l'élément rayonnant 10 et par son entrée à une sortie d'émission S du circuit multifonctions pour fournir un signal de puissance à émettre par l'élément rayonnant et un amplificateur de réception à faible bruit AFB 25 amplifiant un signal de réception capté par l'élément rayonnant pour être appliqué à une entrée de réception E du circuit multifonctions.

Le circuit multifonctions 20 comporte une voie commune de modulation de signal 22 et une section de commutation comportant trois commutateurs C1, C2, C3 ayant chacun un plot commun Pa et deux plots libres Pb, Pc. Ces commutateurs C1, C2, C3 sont communément appelés « SPDT» (pour : « Single Path, Double Through » en langue anglaise), ou commuteurs « 1 vers 2 ».

Dans cet exemple de module, la voie commune de modulation de signal 22 comporte, entre une entrée Evc et une sortie Svc de signal, un atténuateur à commande électronique 26, des blocs de gain 28 et un déphaseur à commande électronique 30.

La voie commune de modulation de signal 22 est connectée entre un premier C1 et un deuxième C2 commutateurs. Un troisième commutateur C3 est connecté par son plot commun Pa à l'accès réception/émission ER du module, par un de ses deux plots libres Pc à un plot libre Pc du premier commutateur C1 et par son autre plot libre Pb à un plot libre Pb du deuxième commutateur C2.

L'autre plot libre du premier commutateur C1 est connecté, par l'intermédiaire de la borne d'entrée réception E du circuit multifonction à la sortie de l'amplificateur faible bruit AFB et l'autre plot libre du deuxième commutateur C2 est connecté, par l'intermédiaire de la sortie émission S du circuit multifonctions à l'entrée de l'amplificateur de puissance AP.

La position des commutateurs C1, C2, C3 est configurée de façon à constituer, d'une part, un circuit de réception, représenté à la figure 1a, formé par une chaîne de réception comportant l'amplificateur faible bruit AFB, le premier commutateur C1 connectant la sortie de l'amplificateur faible bruit AFB avec l'entrée Evc de la voie commune de modulation de signal 22 et le deuxième commutateur C2 connectant la sortie Svc de la voie commune de modulation de signal 22 à travers le troisième commutateur C3 avec l'accès ER du module et, d'autre part, un circuit d'émission représenté à la figure 1 b formé par une chaîne d'émission comportant le troisième commutateur C3 connecté par le premier commutateur C1 à l'entrée Evc de la voie commune de modulation de signal 22, le deuxième commutateur C2 connectant la sortie Svc de la voie commune de modulation de signal 22, par l'intermédiaire de la sortie S du module, à l'amplificateur de puissance AP.

Le sens de passage du signal dans la voie commune de modulation de signal 22 représenté dans les figures 1a et 1b par une flèche Fs est le même dans les deux configurations, de réception et d'émission.

Les voies d'émission et de réception sont connectées à l'élément antennaire 10 via un duplexeur non représenté sur les figures 1 a et 1b. Le duplexeur assurant la discrimination entre réception et émission par le même élément rayonnant est réalisé généralement par un circulateur simple ou multiple.

L'accès bidirectionnel ER du module, commun à la réception et à l'émission, est connecté à une voie commune de traitement de signal extérieure au module qui permet, soit de générer l'onde à émettre, soit d'analyser l'onde reçue.

Le circuit multifonction a deux rôles principaux :
Premièrement l'amplification et la modulation vectorielle du signal qui le traverse, c'est à dire le contrôle en amplitude à l'aide des blocs de gains 28 combinés à l'atténuateur commandable 26 et en phase, à l'aide du déphaseur commandable 30 de ce signal. Il faut noter que cette section du circuit est parcourue par le signal dans le même sens (flèche Fs) en émission et en réception, de par les blocs de gain 28 nécessaires qui sont unilatéraux.
Deuxièmement, la commutation du signal pour qu'il suive un des deux chemins suivants, de telle manière que la section de modulation vectorielle soit parcourue dans un sens unique:
   - de la voie commune de traitement extérieure vers l'antenne, via l'amplificateur de puissance AP en mode émission
   - de l'antenne vers la voie commune de traitement extérieure via l'amplificateur faible bruit AFB en mode réception.

Dans le cas de modules réalisés en technologie MMIC (Monolithic Microwave Integrated Circuits), utilisant un substrat semi-conducteur de type dit « III-V » (typiquement l'Arséniure de Gallium, GaAs), les commutateurs C1, C2, C3 sont réalisés à partir de transistors à effet de champ, désignés par l'acronyme TEC, dont le drain n'est pas polarisé par rapport à la source. Dans ce type d'utilisation, les transistors à effet de champ sont qualifiés de TECs « froids », par opposition aux transistors polarisés entre drain et source, capables d'amplifier un signal qui sont alors qualifiés de TECs« chauds ».

Un TEC « froid » peut être assimilé, en première approximation, à une résistance entre drain et source dont la valeur est commandée par une tension Vg appliquée entre grille et source (ou entre grille et drain, le TEC « froid » pouvant être considéré comme symétrique).

Toujours en première approximation, l'électrode de grille du TEC ne sert que comme électrode de commande et n'intervient pas directement dans le fonctionnement en hyperfréquence du circuit.

Pour une valeur « haute » de la tension Vg entre la grille et la source, le TEC est passant, la résistance équivalente entre le drain et la source est de faible valeur.

Pour une valeur « basse » de la tension Vgs, le TEC est bloqué, la résistance équivalente entre le drain et la source est de forte valeur.

Les TECs froids sont ainsi insérés dans le circuit du module soit en série, soit en parallèle, soit selon une combinaison de transistors en série et en parallèle afin de réaliser la commutation souhaitée.

Un élément de commutation réalisé par un TEC froid série sera à l'état bloqué quand le TEC est bloqué, à l'état passant quand le TEC est passant. Cette règle est inversée pour un élément de commutation réalisé par un TEC froid en parallèle (dont une des électrodes est reliée à la masse).

Dans le cas des modules actifs pour antennes à balayage électronique, le gain total apporté par le circuit multifonction, réalisé en général sur une seule puce MMIC (Monolithic Microwave Integrated Circuits, en langue anglaise), doit souvent être important (typiquement 20 à 30 dB) ce qui impose de forts niveaux d'isolement pour éviter les rebouclages parasites générateurs d'instabilité ou d'ondulation des caractéristiques électriques dans la bande passante. En utilisant des TECs froids, il en résulte des cellules de commutation multiples, des combinaisons série parallèle et des structures qui présentent deux inconvénients :
- les pertes sont relativement importantes et sont situées à proximité immédiate des accès. En mode réception, les pertes en entrée viennent directement s'ajouter au facteur de bruit du circuit multifonction. En mode émission, elles obligent à surdimensionner le dernier bloc amplificateur AP pour délivrer la puissance requise au niveau de l'antenne 10, ce qui conduit à une surconsommation d'énergie.
- les dimensions de ces structures de commutation sont importantes, ce qui peut donner naissance à des couplages parasites par influence électromagnétique.

A titre d'exemple et en prenant pour hypothèse une puce multifonction sur GaAs pour réaliser le module selon les figures 1 a et 1 b, la totalité du gain est localisé dans la partie centrale de la chaîne par les blocs de gain 28 et représente une valeur typique de 40 dB pour, compte tenu des pertes, obtenir environ 30 dB de gain total effectif.

Les commutateurs passifs à TECs froids C1, C2 auront une taille de plusieurs centaines de µm et seront situés de part et d'autre de la section active avec entre eux une distance qui peut être de l'ordre du mm. Ces dimensions peuvent correspondre à un couplage électromagnétique de l'ordre de -50dB qui, combiné au gain de la partie active, peut conduire à un gain de boucle d'environ -20 dB. Cette valeur n'est pas suffisante pour générer un accrochage (oscillation parasite) mais elle suffit pour provoquer une ondulation de plusieurs dB sur le gain et les coefficients de réflexion aux accès du module. Cette ondulation peut être rédhibitoire au niveau du système global.

Afin de pallier les inconvénients des structures de commutation dans les circuits hyperfréquences de l'état de l'art, l'invention propose un dispositif de commutation de signaux hyperfréquences pour circuit intégré fonctionnant dans une bande de fréquence étroite,
caractérisé en ce qu'il comporte des éléments de commutation actifs et passifs en cascade desdits signaux hyperfréquences, un élément de commutation actif ayant un transistor à effet de champ, dit transistor chaud, polarisé par une tension Vd appliquée entre le drain D et la source S et commandé par une tension de polarisation appliquée à sa grille G pour rendre ce transistor chaud, soit amplificateur, soit bloqué pour les signaux hyperfréquences, un l'élément de commutation passif ayant transistor à effet de champ, dit transistor froid, commandé par une autre tension de polarisation appliquée à sa grille G pour rendre ce transistor froid, soit passant, soit bloqué pour lesdits signaux hyperfréquences, des moyens de génération CM des tensions de polarisation des transistors.

Avantageusement le dispositif de commutation comporte, en outre, des lignes quart d'onde à la fréquence de fonctionnement du circuit entre au moins deux éléments de commutation en cascade pour augmenter l'efficacité d'isolement entre lesdits éléments.

L'invention concerne aussi un circuit intégré hyperfréquences pour antenne à balayage électronique comportant une voie commune de modulation ayant une entrée Evc et une sortie Svc, le circuit intégré comportant en outre un accès bidirectionnel ER, une entrée de réception E d'un signal reçu par une antenne et une sortie S fournissant un signal d'émission à ladite antenne. Le circuit intégré hyperfréquences comporte un dispositif de commutation selon l'invention, pour commuter la voie commune de modulation, soit entre l'accès bidirectionnel ER et l'entrée de réception E, soit entre l'accès bidirectionnel ER et la sortie d'émission S du circuit intégré.

Un principal objectif du circuit hyperfréquences selon l'invention est de réduire à la fois la taille physique des structures de commutation hyperfréquences des circuits intégrés complexes, les pertes associées et les couplages parasites.

Pour parvenir à ces résultats, l'idée est de combiner la fonction commutation et la fonction amplification des transistors à effet de champs pour réaliser des commutateurs actifs.

L'invention sera mieux comprise à l'aide d'exemple de réalisation d'un dispositif de commutation, et d'un module comportant un tel dispositif de commutation en référence aux dessins indexés dans lesquels :
- les figures 1a et 1b, déjà décrites, représentent un schéma synoptique d'un module associé à un élément rayonnant élémentaire d'une antenne à balayage électronique ;
- la figure 2a montre un élément de commutation dit « actif » ;
- la figure 2b représente, sous forme de symbole, un élément de commutation actif comportant un transistor à effet de champ monté en amplificateur ;
- la figure 3a montre un élément de commutation passif série ;
- la figure 3b représente le symbole de l'élément de commutation de la figure 3a ;
- la figure 4a montre un élément de commutation passif parallèle ;
- la figure 4b représente un symbole de l'élément de la figure 4a comportant un transistor en interrupteur parallèle ;
- les figures 5a et 5b montrent un exemple d'application du dispositif de commutation actif à un module électronique ;
- la figure 6a représente le symbole d'une ligne quart d'onde ;
- la figure 6b le schéma d'un circuit, réalisée en composants localisés, capable de reproduire approximativement, autour de sa fréquence centrale, le comportement de ligne de la figure 6a ;
- la figure 7a montre une configuration d'une cellule de commutation comprenant deux lignes quart d'onde et deux transistors froids en parallèle et ;
- les figures 7b et 7c montrent respectivement les pertes et l'isolation en dB en fonction de la fréquence F de fonctionnement de la configuration de la figure 7a.

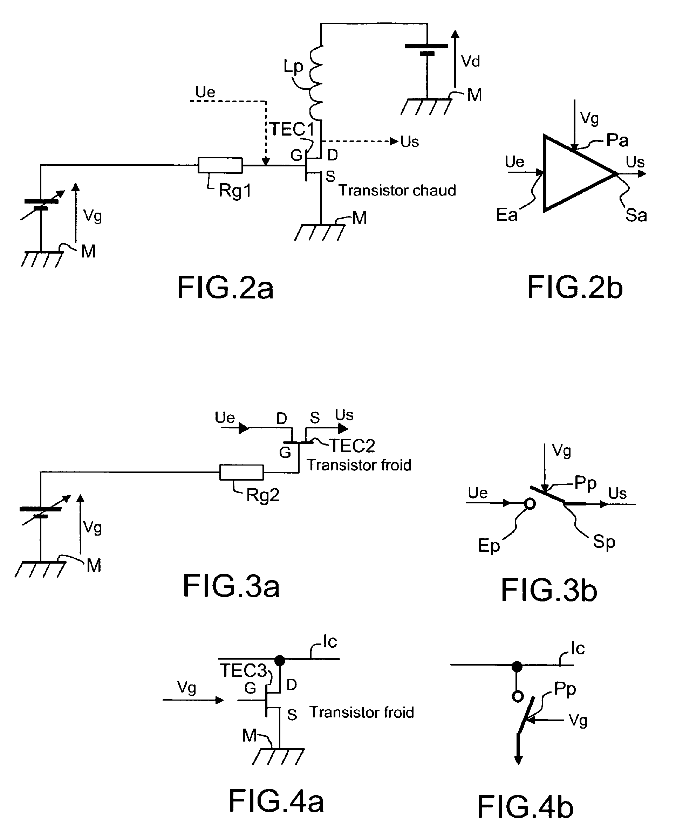

La figure 2a montre un élément de commutation actif de signaux hyperfréquences comportant un transistor à effet de champ TEC1 en montage amplificateur.

Le drain D du transistor chaud TEC1 est polarisé à travers une self de découplage Lp par un potentiel Vd continu par rapport à un potentiel de référence M, la source S étant connectée audit potentiel de référence M. La grille G du transistor chaud est polarisée à travers une résistance Rg1 par une tension de grille Vg par rapport au potentiel de référence M.

D'autres moyens de polarisation du drain D du transistor chaud TEC1 sont utilisables par exemple, une « charge saturable » ou « charge active », comportant un transistor fonctionnant en source de courant, peut remplacer la self de découplage Lp. On peut aussi utiliser une structure dite « autopolarisation » pour la grille G consistant à mettre la grille à la masse en courant continu à travers une résistance ou une self et insérer une résistance découplée (par un condensateur en parallèle) dans la source S pour remonter le potentiel continu de source. Ce procédé est connu et permet d'économiser une source de tension de grille et de mieux stabiliser le dispositif en température. Dans notre application, il faudra commuter le potentiel de grille entre 0Volt et un potentiel bloquant le TEC1.

La tension de grille Vg appliquée à la grille du transistor chaud TEC1 est rendue variable de façon à commander le fonctionnement du transistor chaud. En pratique la tension de grille Vg du tansistor chaud TEC1 peut prendre deux niveaux, soit un niveau haut Ha pour faire fonctionner le transistor chaud en amplificateur, soit un niveau bas Ba pour le mettre dans un état bloqué pour les signaux hyperfréquences.

Le potentiel de référence peut être une masse M du circuit.

Lorsqu'un signal d'entrée Ue hyperfréquences est appliqué à la grille G:
- en fonctionnement en amplificateur, le transistor fourni sur le drain D un signal de sortie Us hyperfréquence amplifié ou peu atténué et,
- lorsque le transistor est à l'état bloqué le signal hyperfréquence d'entrée Ue se trouve fortement atténué au niveau du drain D du transistor.

Dans cette configuration du transistor chaud TEC1 :
- le fonctionnement en amplificateur est obtenu pour des tensions Vg appliquées à la grille G comprises entre -0,4volt et 0 volt.
- l'état bloqué est obtenu pour des tensions Vg appliquées à la grille G comprises entre -1,5volt et -0,8 volts.

La figure 2b représente, sous forme de symbole, un élément de commutation actif comportant le transistor à effet de champ TEC1 monté en amplificateur, ou transistor chaud, et dont le schéma de principe est représenté à la figure 2a. L'élément de commutation actif comporte une entrée de signal Ea, une sortie de signal amplifié Sa et une entrée de polarisation Pa du transistor de l'élément de commutation actif.

La figure 3a montre un élément de commutation passif comportant un transistor à effet de champ TEC2 dit « froid » en série.

Dans ce montage du TEC froid, le signal hyperfréquence d'entrée Ue est appliqué au drain D du transistor. Le signal de sortie Us se retrouve au niveau de la source S avec une atténuation variable en fonction de polarisation de grille Vg. Le transistor se comporte dans cette configuration comme une résistance variable entre drain D et source S en fonction de la tension de grille Vg.

La figure 3b représente le symbole de l'élément de commutation de la figure 3a sous forme d'un interrupteur et comporte une entrée de signal Ep, une sortie de signal Sp et une entrée de polarisation du transistor passif Pp.

La figure 4a montre un élément de commutation passif monté dans un circuit en parallèle comportant un transistor à effet de champ froid TEC3.

La figure 4b représente un symbole de l'élément de la figure 4a comportant un transistor en interrupteur parallèle. Dans cette configuration de montage du transistor TEC3 froid en parallèle, le drain D du transistor TEC est connecté par exemple à une ligne Ic sous un potentiel de signal hyperfréquence et la source S à un potentiel de référence, par exemple une masse M. Une commande de polarisation Vg sur la grille permet de mettre le TEC3 froid, soit dans un état passant court-circuitant le signal hyperfréquence à la masse M, soit dans un état bloqué isolant le signal de la ligne Ic de la masse M.

Dans ces montages des figures 3a et 4a des transistors à effet de champ TEC2, TEC3 froids fonctionnant en commutateur passif, série ou parallèle,
- l'état passant du transistor froid TEC2, TEC3 est obtenu pour des tensions de grille Vg comprises entre + 0,3volt et 0.6volt volts ;
- l'état bloqué du transistor froid TEC2, TEC3 est obtenu pour des tensions de grille Vg comprises entre -2 volts et -2,5 volts.

Ces fourchettes de tension pouvent être plus larges.

Ces valeurs de tension de grille Vg, pour obtenir des états bloques et des états saturés des TECs correspondent typiquement à des dispositifs sur GaAs. D'autres matériaux peuvent parfaitement être envisagés pour ces circuits (en utilisant également des TECs), en particulier le Nitrure de Gallium (GaN), possédant des tensions de claquage beaucoup plus importantes et des performances supérieures en puissance et en robustesse. Dans ce cas, les valeurs absolues de la tension de grille Vg seront nettement plus élevées.

Dans ce type de transistors TEC2, TEC3 froid utilisés dans un circuit que ce soit en série ou en parallèle, le drain D et la source S sont symétriques, la tension d'entrée Ue peut donc être appliquée à la source S et sortir par le drain D ou inversement.

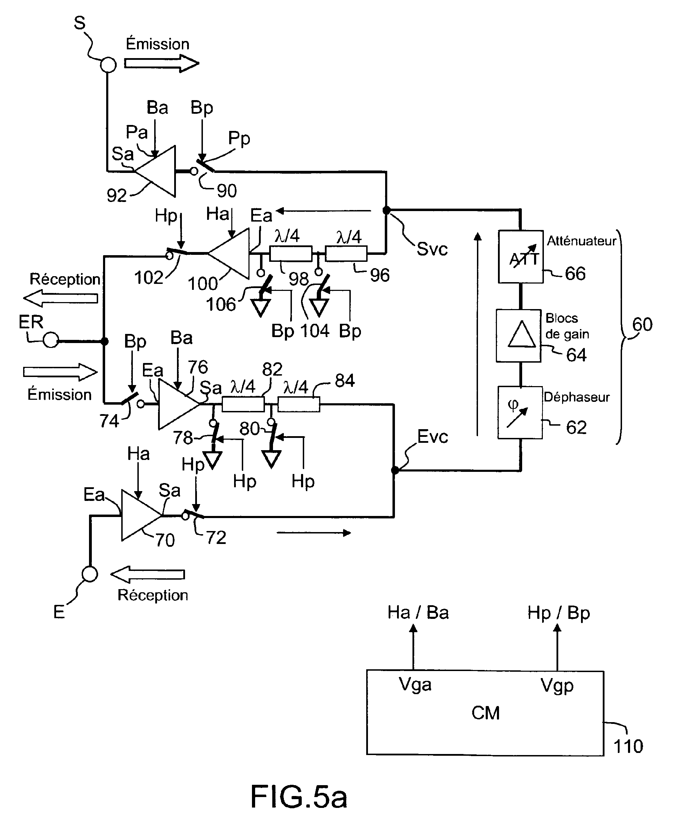

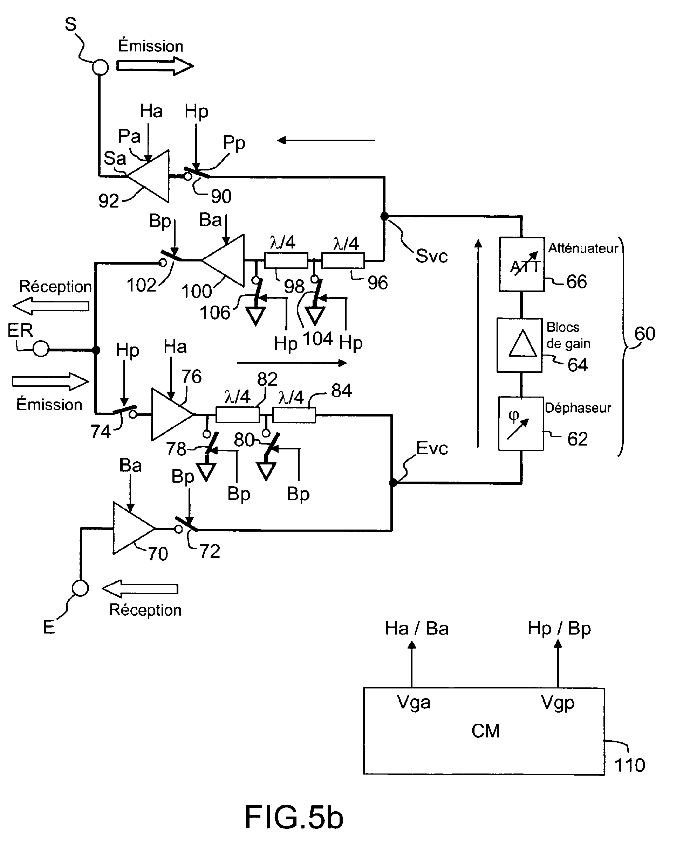

Les figures 5a et 5b montrent un exemple d'application du dispositif de commutation actif à un module électronique (ou circuit intégré) d'une antenne à balayage électronique.

Le circuit intégré hyperfréquences, selon l'invention, pour antenne à balayage électronique des figures 5a et 5b comporte une voie commune de modulation de signal 60, un accès bidirectionnel d'émission/réception ER, une entrée de réception E d'un signal reçu par une antenne élémentaire (non représentés sur la figure) et une sortie S fournissant un signal d'émission à l'antenne élémentaire.

Dans cette réalisation, le circuit intégré comporte un dispositif de commutation selon l'invention pour mettre le circuit intégré, soit dans une configuration de réception commutant la voie commune de modulation entre l'accès bidirectionnel ER et l'entrée de réception E, soit dans une configuration d'émission commutant la voie commune de modulation entre l'accès bidirectionnel ER et la sortie d'émission S.

La voie commune de modulation de signal 60 comporte entre une entrée Evc de la voie et une sortie Svc de la dite voie, un déphaseur à commande électronique 62 un bloc amplificateur 64 un atténuateur à commande électronique 66.

Le module pour antenne à balayage électronique des figures 5a et 5b comporte :
- entre l'entrée de réception E du circuit et l'entrée Evc de la voie commune de modulation 60, un élément de commutation actif 70 en série avec un élément de commutation passif 72, l'entrée Ea de l'élément actif 70 étant connectée à l'entré de réception E du circuit intégré,
- entre l'accès bidirectionnel ER et l"entrée Evc de la voie commune de modulation 60, quatre éléments de commutation en cascade, un premier élément de commutation passif 74 en série avec un élément de commutation actif 76, l'entrée Ea de l'élément de commutation actif 76 étant connectée à l'entrée bidirectionnel ER du circuit à travers le premier élément passif 74, un deuxième élément de commutation passif 78 connecté en parallèle entre la sortie Sa de l'élément de commutation actif 76 et un potentiel de référence M, un troisième élément passif 80 connecté en parallèle entre la sortie Sa de l'élément de commutation actif 76 par l'intermédiaire d'une première ligne quart d'onde 82 et le potentiel de référence, une deuxième ligne quart d'onde 84 reliant le point commun entre le troisième élément passif 80 et la première ligne quart d'onde 82 à l'entrée Evc de la voie commune de modulation 60,

- entre la sortie Svc de la voie commune de modulation 60 et la sortie d'émission S du circuit, deux éléments de commutation en cascade, un élément de commutation passif 90 en série avec un élément de commutation actif 92, la sortie Sa de l'élément de commutation actif 92 étant connectée à la sortie d'émission S du circuit intégré et,
- entre la sortie Svc de la voie commune de modulation 60 et l'accès bidirectionnel ER du module quatre éléments de commutation en cascade, une première 96 et une deuxième 98 lignes quart d'onde connectées en série avec l'entrée Ea d'un élément de commutation actif 100, la sortie Sa de l'élément de commutation actif 100 étant connecté à la sortie bidirectionnelle ER à travers un premier élément de commutation passif 102 en série, un deuxième élément de commutation passif 104 connecté en parallèle entre le point commun des première 96 et deuxième 98 lignes quart d'onde en série et le potentiel de référence M, un troisième élément de commutation passif 106 connecté en parallèle entre le point commun de la deuxième ligne 98 quart d'onde et l'entrée Ea de l'élément de commutation actif 100 et le potentiel de référence M.

Le dispositif de commutation comporte des moyens intégrés au module de génération des polarisations des transistors des éléments de commutation. Ces moyens dans le module (ou circuit intégré hyperfréquence) sont par exemple un circuit de commande CM 110 fournissant les tensions de polarisation :
- une tension de polarisation Vga pour les éléments de commutation actifs pouvant prendre, soit une première valeur Ha mettant l'élément de commutation actif en amplificateur, soit une deuxième valeur Ba mettant l'élément de commutation actif à l'état bloqué,
- une autre tension de polarisation Vgp pour les éléments de commutation passifs pouvant prendre, soit une première valeur Hp mettant l'élément de commutation passif passant, soit une deuxième valeur Bp mettant l'élément de commutation passif bloqué.

Ces tensions de polarisation Vga et Vgp sont choisies dans une plage de valeurs telle que définies précédemment.

Nous allons par la suite décrire le fonctionnement du module d'émission/réception des figures 5a et 5b.

Le circuit de commande CM 110 du module fourni les polarisations nécessaires aux transistors TEC des éléments de commutation actifs et passifs du dispositif de commutation du module tel que décrit précédemment.

La figure 5a représente le module en position réception montrant les polarisations Ha, Ba, Hp, Bp appliqués aux différents éléments de commutation du module.

En position réception, sont commandés simultanément,
d'une part :
- entre l'entrée de réception E du circuit et l'entrée Evc de la voie commune de modulation 60 l'élément de commutation actif 70 est commandé en amplificateur et l'élément de commutation passif 72 en série en interrupteur fermé (passant). Le signal d'antenne à l'entrée E réception est amplifié par le transistor chaud de l'élément de commutation actif 70 pour être appliqué, à travers l'interrupteur de l'élément de commutation passif 72, à l'entrée Evc de la voie commune de modulation 60, et
- entre la sortie Svc de la voie commune de modulation 60 et l'accès bidirectionnel ER du module, l'élément de commutation actif 100 est commandé en amplificateur, le premier élément de commutation passif 102 étant commandé en interrupteur fermé (passant), les deuxième 104 et troisième 106 éléments de commutation passifs en parallèle étant commandés en interrupteur ouvert (bloqué). Le signal en sortie Svc de la voie commune de modulation 60 est ainsi appliqué à l'accès bidirectionnel ER.

Le circuit de réception est établit entre l'entrée de réception E et l'accès bidirectionnel ER par la voie commune de modulation 60
- entre la sortie Svc de la voie commune de modulation 60 et la sortie d'émission S du circuit, élément de commutation actif 92 est commandé bloqué et l'élément de commutation passif série 90 est commandé en interrupteur ouvert (bloqué) isolant la sortie S du circuit intégré de la voie commune de modulation 60 et,
- entre l'accès bidirectionnel ER et l"entrée Evc de la voie commune de modulation 60 le premier élément de commutation passif 74 en série est commandé en interrupteur ouvert (bloqué), élément de commutation actif 76 étant commandé en transistor bloqué, le deuxième élément de commutation passif 76 en parallèle et le troisième élément passif 78 en parallèle avec le deuxième élément passif 80 séparé du premier par la première ligne quart d'onde 82, sont commandés en interrupteurs fermés (passants) améliorant l'isolement entre l'accès bidirectionnel ER et l'entrée Evc de la voie commune de modulation. La deuxième ligne quart d'onde 84 ramène, dans cette configuration à la fréquence centrale de fonctionnement du circuit, le court circuit produit par la fermeture du troisième interrupteur 80, en une impédance idéalement infinie au niveau de l'entrée Evc de la voie commune de modulation 60.

La figure 5b représente le module en position émission montrant les polarisations Ha, Ba, Hp, Bp appliqués aux éléments de commutation du module

En position émission toutes les polarisations des transistors des éléments de commutation sont inversées par rapport aux polarisations en réception de façon à passer en configuration du module en émission. Une polarisation haute Hp d'un transistor passif devenant basse Bp ou le contraire, une polarisation haute Ha d'un transistor actif devenant basse Ba ou le contraire selon l'élément de commutation considéré.

Dans la configuration d'émission, un signal hyperfréquence appliqué à l'accès bidirectionnelle ER se trouve appliqué à l'entrée Evc de la voie commune de modulation 60 après amplification par l'élément de commutation actif 76 entre cet accès bidirectionnel ER et l'entrée Evc de la voie commune de modulation 60. Le signal en sortie de la voie commune de modulation 60 est amplifié par l'élément de commutation actif 92 entre la sortie Svc de la voie commune de modulation 60 et la sortie émission S du circuit intégré.

En pratique dans le module selon l'invention représenté aux figures 5a et 5b, chacune des voies conduisant au port commun, lorsqu'elle est bloquée, présente un isolement très élevé, compris entre -60 et -80 dB. Cet isolement est nécessaire pour éviter une boucle interne, à travers la section centrale du circuit intégré, génératrice d'instabilité ou d'ondulations des réponses en fréquence. Dans d'autres conditions (gains différents en particulier), on pourra soit augmenter le nombre de cellules pour obtenir un isolement plus important (avec cependant des limites physiques) soit le diminuer si un isolement plus faible est tolérable.

On peut constater sur les figures 5a et 5b les principaux avantages du circuit intégré selon l'invention :
L'entrée E de la voie réception est immédiatement suivie d'un amplificateur 70 (élément de commutation actif), sans commutateur passif en amont, donc sans pertes : le facteur de bruit de la puce s'en trouve amélioré.
La sortie S de la voie d'émission est immédiatement précédée d'un bloc amplificateur 92 (élément de commutation actif), sans commutateur passif, donc sans pertes: le bloc amplificateur 92 peut donc être dimensionné pour les besoins exacts en termes de puissance de sortie.
Cette proximité entre les accès de la puce (ou module) et les blocs de gain limite de manière très significative les possibilités de couplage électromagnétique parasite entre ces régions. La stabilité de la puce est renforcée et les risques d'ondulation fortement diminués.
La partie amplificatrice de la puce est répartie entre les blocs de gain servant également de commutateurs (éléments de commutation actifs 70, 76, 100, 92) et ceux restant dans la voie commune de modulation (blocs de gain 64). De ce fait, la voie commune de modulation a un gain beaucoup plus limité et est donc beaucoup moins sensible aux couplages parasites entre éléments connectés à ses accès.

Sur les quatre éléments de commutation actifs (blocs amplificateurs) seuls deux sont en mode amplificateur (les deux en mode réception ou les deux en modes émission), les deux autres dans chacun des modes sont bloqués.

La consommation globale équivaut donc à celle de deux amplificateurs. En outre, les amplificateurs activés en mode réception étant différents de ceux activés en mode émission, chacun d'eux peut être dimensionné de manière spécifique selon les niveaux de puissance ou de linéarité requis, ce qui permet dans certains cas de diminuer significativement la consommation globale de la puce.

La partie de la fonction commutation qui est assurée par la commande des amplificateurs (commutation active) n'est associée à aucune perte série comme dans le cas d'un commutateur passif de l'état de l'art : on gagne donc globalement les pertes associées à un commutateur passif, ce qui permet soit d'obtenir un gain global plus important soit d' « économiser » un étage de gain et donc de gagner sur la consommation totale.

Les quatre étages amplificateurs représentés par des triangles sur les figures 5a et 5b remplacent deux amplificateurs dans la réalisation habituelle. Cependant, on a vu que ces quatre amplificateurs ne consommaient pas plus (activation alternée) et qu'ils pouvaient consommer moins grâce à un dimensionnement spécifique et à l'élimination de certaines pertes associées à des transistors froids.

De plus, le nombre total de transistors du module selon l'invention est plus faible que le nombre dans une structure équivalente de l'état de l'art car un transistor chaud commuté a plus d'efficacité en commutation qu'un transistor froid.

A titre d'exemple, une réalisation d'un module selon l'invention tel que représenté aux figures 5a et 5b utilise, pour la section de commutation active, un total de 13 transistors (dont 4 « chauds »). La réalisation selon le procédé habituel de l'état de l'art de commutation passive utilise, pour réaliser la même fonction (en incluant donc 2 étages d'amplification), un total de 23 transistors. Globalement, l'architecture du module selon l'invention permet de diminuer le nombre de composants et de réduire la surface totale de la puce.

Le module selon l'invention possède encore un autre avantage potentiel : le nombre total de transistors étant réduit de manière significative, la nouvelle architecture sera moins sensible aux variations des paramètres électriques de ce composant, liées aux dispersions des paramètres technologiques.

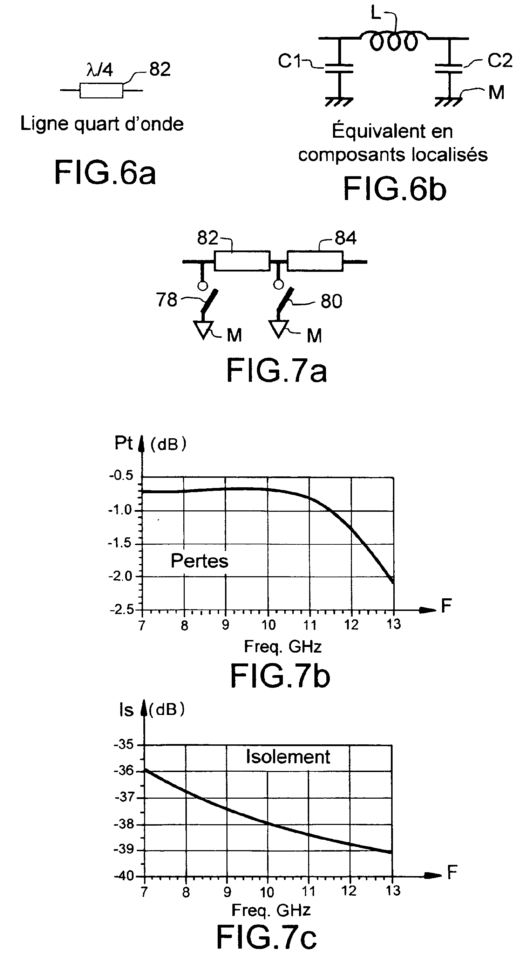

Dans une réalisation particulière du module selon l'invention, les lignes quart d'onde peuvent être par exemple réalisées en composant localisés. La figure 6a représente le symbole d'une ligne quart d'onde λ/4 et la figure 6b le schéma d'un circuit, réalisée en composants localisés, capable de reproduire approximativement, autour de sa fréquence centrale, le comportement de ligne de la figure 6a

Sur une bande de fréquences modérée (jusqu'environ 50% de largeur de bande par rapport à la fréquence centrale), un tronçon de ligne quart d'onde λ/4 (λ étant la longueur d'onde du signal hyperfréquence de fonctionnement du circuit) peut être réalisé à l'aide d'un circuit simple en Pi comprenant une inductance L et deux capacités C1, C2 connectée au potentiel de référence M selon le schéma indiqué sur la figure 6b.

Pour comprendre le principe de combinaison d'éléments de commutation comportant des transistors dits « froids » et « chauds » dans la réalisation du dispositif de commutation selon l'invention, il est utile de noter quelques ordres de grandeur.

Un transistor froid de taille « moyenne » en configuration série, entre deux portes référencées sur des impédances de 50 Ω, présente en bande X des pertes d'environ 1,5 dB et un isolement d'environ 15 dB, soit 12 à 13 dB de différence entre les 2 états.

Un transistor chaud dans un montage à contre-réaction série (une inductance est insérée dans la source du transistor pour assurer une stabilité inconditionnelle sur une large bande de fréquences) présente un gain de l'ordre de 10 dB en étant polarisé en amplificateur et un isolement supérieur à 10dB en étant bloqué, soit plus de 20 dB de différence entre les 2 états.

Pour concilier de faibles pertes et un fort isolement avec des transistors froids, un tronçon de ligne quart d'onde est inséré entre les deux transistors. Ce résonateur quart d'onde agit, sur une bande de fréquence modérée, comme un transformateur d'impédance qui va amplifier l'effet de court-circuit apporté par les transistors passants lorsque le commutateur est dans l'état bloqué.

La figure 7a montre une configuration d'une cellule de commutation comprenant deux lignes quart d'onde 82, 84 et deux transistors froids 78, 80 en parallèle.

Les figures 7b et 7c montrent respectivement les pertes Pt et l'isolement Is en dB en fonction de la fréquence F de fonctionnement de la configuration de la figure 7a. Les pertes sont de l'ordre de 0,8dB et l'isolement de 38 dB.

Le circuit de commande 110 du module selon l'invention peut être aussi configuré pour générer en plus des commandes des éléments de commutation en mode réception ou en mode émission, un troisième mode dit « tout éteint », pour lequel toutes les voies du module sont bloquées. Ce mode « tout éteint » peut être associé à une charge annexe sur un ou plusieurs des accès du circuit intégré, mise en service au travers par exemple un commutateur à transistor froid série, pour présenter aux accès équipés de cette charge une impédance proche de 50 Ω.

Dans cette configuration de mode « tout éteint », les éléments actifs du circuit intégré sont à l'état bloqué, les éléments passifs série sont à l'état bloqué (interrupteurs ouverts) et les éléments passifs parallèle sont à l'état passant (interrupteurs fermés)

La description de l'exemple de réalisation des figures 5a et 5b n'est pas limitatif, la structure décrite n'étant qu'une réalisation parmi d'autres de l'idée faisant l'objet de l'invention, en effet l'invention comporte deux aspects principaux :
- l'utilisation de transistors (chauds) pour combiner les fonctions amplification et commutation (dite commutation active) ;
- la combinaison de cellules de commutation actives et de cellules passives (à transistors froids) pour en particulier augmenter l'isolement.

Ces aspects de l'invention peuvent se décliner de différentes manières, nombre de cellules, d'éléments dans une cellule, combinaisons des cellules ou autres combinaisons avec ou sans lignes quart d'onde d'isolement.

## Revendications

1. Dispositif de commutation de signaux hyperfréquences pour circuit intégré fonctionnant dans une bande de fréquence étroite,
**caractérisé en ce qu'**il comporte des l'éléments de commutation actifs (70, 76, 92, 100) et passifs (72, 74, 78, 80, 90, 102, 104, 106) en cascade desdits signaux hyperfréquences, un élément de commutation actif ayant un transistor à effet de champ (TEC1), dit transistor chaud, polarisé par une tension Vd appliquée entre le drain D et la source S et commandé par une tension de polarisation (Vg) appliquée à sa grille G pour rendre ce transistor chaud, soit amplificateur, soit bloqué pour les signaux hyperfréquences, un l'élément de commutation passif ayant un transistor à effet de champ (TEC2, TEC3), dit transistor froid, commandé par une autre tension de polarisation appliquée à sa grille G pour rendre ce transistor froid soit passant soit bloqué pour lesdits signaux hyperfréquences, des moyens de génération CM (110) des tensions de polarisation des transistors.

2. Dispositif de commutation selon la revendication 1, **caractérisé en ce qu'**il comporte, en outre, des lignes quart d'onde (82, 84, 96, 98) à la fréquence (F) de fonctionnement du circuit entre au moins deux éléments de commutation en cascade (78, 80), (96, 98) pour augmenter l'efficacité d'isolement entre lesdits éléments.

3. Dispositif de commutation selon l'une des revendications 1 ou 2, **caractérisé en ce que** le drain D du transistor chaud (TEC1) est polarisé à travers une self de découplage (Lp) par un potentiel (Vd) continu par rapport à un potentiel de référence (M), la source S étant connectée audit potentiel de référence (M), la grille G du transistor chaud étant polarisée à travers une résistance (Rg1) par une tension de grille (Vg) par rapport au potentiel de référence (M).

4. Dispositif de commutation selon l'une des revendications 1 ou 2, **caractérisé en ce que** des moyens de polarisation du drain D du transistor chaud (TEC1) comportent un transistor fonctionnant en source de courant.

5. Dispositif de commutation selon l'une des revendications 1 à 4, **caractérisé en ce que** la tension de grille (Vg) du tansistor chaud (TEC1) peut prendre deux niveaux, soit un niveau haut Ha pour faire fonctionner le transistor chaud en amplificateur, soit un niveau bas Ba pour le mettre dans un état bloqué pour les signaux hyperfréquences.

6. Dispositif de commutation selon l'une des revendications 1 à 5, **caractérisé en ce que** le fonctionnement en amplificateur du transistor chaud (TEC1) est obtenu pour des tensions de polarisation (Ha) appliquées à la grille G comprises entre -0,4volt et 0 volt, l'état bloqué étant obtenu pour des tensions appliquées à la grille G (Ba) comprises entre -1,5volt et -0,8 volts.

7. Dispositif de commutation selon l'une des revendications 1 à 6, **caractérisé en ce que** les transistors à effet de champ froids (TEC2, TEC3) fonctionnant en commutateur passif, série ou parallèle, l'état passant du transistor froid (TEC2, TEC3) est obtenu pour des tensions de grille (Vg) comprises entre + 0,3volt et 0.6volt, l'état bloqué du transistor froid (TEC2, TEC3) étant obtenu pour des tensions de grille (Vg) comprises entre -2 volts et -2,5 volts.

8. Dispositif de commutation selon l'une des revendications 1 à 7, **caractérisé en ce que** l'élément de commutation actif comporte une entrée de signal Ea, une sortie de signal amplifié Sa et une entrée de polarisation Pa du transistor de l'élément de commutation (TEC1) actif

9. Dispositif de commutation selon l'une des revendications 1 à 8, **caractérisé en ce que** l'élément de commutation passif comporte une entrée de signal Ep, une sortie de signal Sp et une entrée de polarisation Pp du transistor de l'élément de commutation passif (TEC2, TEC3).

10. Circuit intégré hyperfréquences pour antenne à balayage électronique comportant une voie commune de modulation (22, 66) ayant une entrée (Evc) et une sortie (Svc), le circuit intégré comportant en outre un accès bidirectionnel ER, une entrée de réception E d'un signal reçu par une antenne et une sortie S fournissant un signal d'émission à ladite antenne, **caractérise en ce qu'**il comporte un dispositif de commutation selon l'une des revendications précédentes, pour commuter la voie commune de modulation (60), soit entre l'accès bidirectionnel ER et l'entrée de réception E, soit entre l'accès bidirectionnel ER et la sortie d'émission S du circuit intégré.

11. Circuit intégré hyperfréquences selon la revendication 10, **caractérisé en ce qu'**il comporte :
- entre l'entrée de réception E du circuit et l'entrée Evc de la voie commune de modulation (60), un élément de commutation actif (70) en série avec un élément de commutation passif (72), l'entrée Ea de l'élément actif (70) étant connectée à l'entré de réception E du circuit intégré,
- entre l'accès bidirectionnel ER et l"entrée Evc de la voie commune de modulation (60), quatre éléments de commutation en cascade, un premier élément de commutation passif (74) en série avec un élément de commutation actif (76), l'entrée Ea de l'élément de commutation actif (76) étant connectée à l'entrée bidirectionnel ER du circuit à travers le premier l'élément passif (74), un deuxième élément de commutation passif (78) connecté en parallèle entre la sortie Sa de l'élément de commutation actif (76) et un potentiel de référence (M), un troisième élément passif (80) connecté en parallèle entre la sortie Sa de l'élément de commutation actif (76) par l'intermédiaire d'une première ligne quart d'onde (82) et le potentiel de référence, une deuxième ligne quart d'onde (84) reliant le point commun entre le troisième élément passif (80) et la première ligne quart d'onde (82) à l'entrée Evc de la voie commune de modulation (60),
- entre la sortie Svc de la voie commune de modulation (60) et la sortie d'émission S du circuit, deux éléments de commutation en cascade, un élément de commutation passif (90) en série avec un élément de commutation actif (92), la sortie Sa de l'élément de commutation actif (92) étant connectée à la sortie d'émission S du circuit intégré et,
- entre la sortie Svc de la voie commune de modulation (60) et l'accès bidirectionnel ER du module quatre éléments de commutation en cascade, une première (96) une deuxième (98) lignes quart d'onde connectées en série avec l'entrée Ea d'un élément de commutation actif (100), la sortie Sa de l'élément de commutation actif (100) étant connecté à la sortie bidirectionnelle ER à travers un premier élément de commutation passif (102) en série, un deuxième élément de commutation passif (104) connecté en parallèle entre le point commun des première (96) et deuxième (98) lignes quart d'onde en série et le potentiel de référence (M), un troisième élément de commutation passif (106) connecté en parallèle entre le point commun de la deuxième ligne (98) quart d'onde et l'entrée Ea de l'élément de commutation actif (100) et le potentiel de référence (M).

12. Circuit intégré hyperfréquences selon l'une des revendications 10 ou 11, **caractérisé en ce que** dans une configuration de mode « tout éteint », les éléments actifs (70, 76, 92, 100) du circuit intégré sont à l'état bloqué, les éléments passifs série (72, 74, 90, 102) sont à l'état bloqué (interrupteurs ouverts) et les éléments passifs parallèle (78, 80, 104, 106) sont à l'état passant (interrupteurs fermés)

13. Circuit intégré hyperfréquences selon l'une des revendications 10 à 12, **caractérisé en ce qu'**il comporte un circuit de commande CM (110) fournissant les tensions de polarisation des éléments de commutation :
- une tension de polarisation (Vga) pour les éléments de commutation actifs (70, 76, 92, 100) pouvant prendre, soit une première valeur Ha mettant l'élément de commutation actif en amplificateur, soit une deuxième valeur Ba mettant l'élément de commutation actif à l'état bloqué,
- une autre tension de polarisation (Vgp) pour les éléments de commutation passifs (72, 74, 78, 80, 90, 102, 104, 106) pouvant prendre, soit une première valeur Hp mettant l'élément de commutation passif passant, soit une deuxième valeur Bp mettant l'élément de commutation passif bloqué.

## Claims

1. A device for switching hyper-frequency signals for an integrated circuit operating in a narrow frequency band,
**characterised in that** it comprises active (70, 76, 92, 100) and passive (72, 74, 78, 80, 90, 102, 104, 106) switching elements in cascade from said hyper-frequency signals, an active switching element having a field effect transistor (TEC1), known as a hot transistor, biased by a voltage Vd applied between the drain D and the source S and controlled by a bias voltage (Vg) applied to its gate G in order to place said hot transistor into either an amplifying or a blocked state for the hyper-frequency signals, a passive switching element having a field effect transistor (TEC2, TEC3), known as a cold transistor, controlled by another bias voltage applied to its gate G in order to place said cold transistor into either a transmitting or a blocked state for said hyper-frequency signals, and MC means (110) for generating the bias voltages of said transistors.

2. The switching device according to claim 1, **characterised in that** it further comprises quarter-wave lines (82, 84, 96, 98) at the operating frequency (F) of the circuit between at least two switching elements (78, 80), (96, 98) in cascade so as to increase the isolating efficiency between said elements.

3. The switching device according to any one of claims 1 or 2, **characterised in that** the drain D of the hot transistor (TEC1) is biased through a decoupling inductor (Lp) via a d.c. potential (Vd) relative to a reference potential (M), the source S being connected to said reference potential (M), the gate G of the hot transistor being biased through a resistor (Rg1) by a gate voltage (Vg) relative to the reference potential (M).

4. The switching device according to any one of claims 1 or 2, **characterised in that** the biasing means of the drain D of the hot transistor (TEC1) comprise a transistor operating as a current source.

5. The switching device according to any one of claims 1 to 4, **characterised in that** the gate voltage (Vg) of the hot transistor (TEC1) can assume two levels, either an upper level Ha to cause the hot transistor to operate in the amplifying state, or a lower level Ba in order to place said hot transistor in the blocked state for the hyper-frequency signals.

6. The switching device according to any one of claims 1 to 5, **characterised in that** operating with the hot transistor (TEC1) in the amplifying state is obtained for bias voltages (Ha) applied to the gate G of between -0.4 volts and 0 volts, the blocked state being obtained for voltages applied to the gate G (Ba) of between -1.5 volts and -0.8 volts.

7. The switching device according to any one of claims 1 to 6, **characterised in that** for cold field effect transistors (TEC2, TEC3) operating as passive, series, or parallel switches, the transmitting state of the cold transistor (TEC2, TEC3) is obtained for gate voltages (Vg) of between + 0.3 volts and 0.6 volts, the blocked state of the cold transistor (TEC2, TEC3) being obtained for gate voltages (Vg) of between -2 volts and -2.5 volts.

8. The switching device according to any one of claims 1 to 7, **characterised in that** the active switching element comprises a signal input Ea, an amplified signal output Sa and a bias input Pa of the transistor of the active switching element (TEC1).

9. The switching device according to any one of claims 1 to 8, **characterised in that** the passive switching element comprises a signal input Ep, a signal output Sp and a bias input Pp of the transistor of the passive switching element (TEC2, TEC3).

10. An integrated hyper-frequency circuit for an electronic scanning antenna, comprising a common modulation channel (22, 66) having an input (Evc) and an output (Svc), said integrated circuit further comprising a two-way access ER, a reception input E for a signal received by an antenna and an output S providing said antenna with an emitting signal, **characterised in that** it comprises a switching device according to any one of the preceding claims for switching the common modulation channel (60) either between the two-way access ER and the reception input E or between the two-way access ER and the emitting output S of the integrated circuit.

11. The integrated hyper-frequency circuit according to claim 10, **characterised in that** it comprises:
- an active switching element (70) in series with a passive switching element (72) between the reception input E of the circuit and the input Evc of the common modulation channel (60), the input Ea of the active element (70) being connected to the reception input E of the integrated circuit,
- four switching elements in cascade between the two-way access ER and the input Evc of the common modulation channel (60), a first passive switching element (74) in series with an active switching element (76), the input Ea of the active switching element (76) being connected to the two-way input ER of the circuit through the first passive element (74), a second passive switching element (78) connected in parallel between the output Sa of the active switching element (76) and a reference potential (M), a third passive element (80) connected in parallel between the output Sa of the active switching element (76) by means of a first quarter-wave line (82) and the reference potential, a second quarter-wave line (84) connecting the common point between the third passive element (80) and the first quarter wave line (82) to the input Evc of the common modulation channel (60),
- two switching elements in cascade between the output Svc of the common modulation channel (60) and the emitting output S of the circuit, a passive switching element (90) in series with an active switching element (92), the output Sa of the active switching element (92) being connected to the emitting output S of the integrated circuit and,
- a first (96) and a second (98) quarter-wave line connected in series with the input Ea of an active switching element (100) between the output Svc of the common modulation channel (60) and the two-way access ER of the module consisting of four switching elements in cascade, the output Sa of the active switching element (100) being connected to the two-way output ER through a first passive switching element (102) in series, a second passive switching element (104) being connected in parallel between the common point of the first (96) and the second (98) quarter-wave lines in series and the reference potential (M), a third passive switching element (106) being connected in parallel between the common point of the second quarter-wave line (98) and the input Ea of the active switching element (100) and the reference potential (M).

12. The integrated hyper-frequency circuit according to any one of claims 10 or 11, **characterised in that** in a configuration of the "All off" mode, the active elements (70, 76, 92, 100) of the integrated circuits are in the blocked state, the passive series elements (72, 74, 90, 102) are in the blocked states (breakers open) and the parallel passive elements (78, 80, 104, 106) are in the transmitting state (breakers closed).

13. The integrated hyper-frequency circuit according to any one of claims 10 to 12, **characterised in that** it comprises a MC control circuit (110) providing the bias voltages of the switching elements:
- a bias voltage (Vga) for the active switching elements (70, 76, 92, 100) being able to assume either a first value Ha placing the active switching element in the amplifying state, or a second value Ba placing the active switching element in the blocked state,
- another bias voltage (Vgp) for the passive switching elements (72, 74, 78, 80, 90, 102, 104, 106) being able to assume either a first value Hp placing the passive switching element in the conducting state, or a second value Bp placing the passive switching element in the blocked state.

## Patentansprüche

1. Bauelement zum Schalten von Hyperfrequenzsignalen für eine integrierte Schaltung, die in einem schmalen Frequenzband arbeitet,
**dadurch gekennzeichnet, dass** sie aktive (70, 76, 92, 100) und passive (72, 74, 78, 80, 90, 102, 104, 106) Schaltelemente in Kaskade von den Hyperfrequenzsignalen umfasst, wobei ein aktives Schaltelement einen Feldeffekttransistor (TEC1) aufweist, heißer Transistor genannt, der von einer zwischen dem Drain D und der Source S angelegten Spannung Vd vorgespannt und mit einer Vorspannung (Vg) gesteuert wird, die an sein Gate G angelegt wird, um den heißen Transistor in einen Verstärkungs- oder einen Sperrzustand für die Hyperfrequenzsignale zu bringen, wobei ein passives Schaltelement einen Feldeffekttransistor (TEC2, TEC3) umfasst, kalter Transistor genannt, der von einer anderen an sein Gate 5 angelegten Vorspannung gesteuert wird, um den kalten Transistor in einen Durchlass- oder einen Sperrzustand für die Hyperfrequenzsignale zu bringen, und MC-Mittel (110) zum Erzeugen der Vorspannungen der Transistoren.

2. Schaltbauelement nach Anspruch 1, **dadurch gekennzeichnet, dass** es ferner Viertelwellenleitungen (82, 84, 96, 98) auf der Betriebsfrequenz (F) der Schaltung zwischen wenigstens zwei Schaltelementen (78, 80), (96, 98) in Kaskade umfasst, um die Isolationseffizienz zwischen den Elementen zu erhöhen.

3. Schaltbauelement nach Anspruch 1 oder 2, **dadurch gekennzeichnet, dass** der Drain D des heißen Transistors (TEC1) durch eine Entkopplungsdrossel (Lp) über ein Gleichspannungspotential (Vd) relativ zu einem Bezugspotential (M) vorgespannt wird, wobei die Source S mit dem Bezugspotential (M) verbunden ist, wobei das Gate G des heißen Transistors durch einen Widerstand (Rg1) mit einer Gate-Spannung (Vg) relativ zu dem Bezugspotential (M) vorgespannt wird.

4. Schaltbauelement nach Anspruch 1 oder 2, **dadurch gekennzeichnet, dass** die Vorspannmittel des Drain D des heißen Transistors (TEC1) einen Transistor umfassen, der als Stromquelle dient.

5. Schaltbauelement nach einem der Ansprüche 1 bis 4, **dadurch gekennzeichnet, dass** die Gate-Spannung (Vg) des heißen Transistors (TEC1) zwei Pegel annehmen kann, entweder einen hohen Pegel Ha, um zu bewirken, dass der heiße Transistor im Verstärkungszustand arbeitet, oder einen tiefen Pegel Ba, um den heißen Transistor in den Sperrzustand für die Hyperfrequenzsignale zu setzen.

6. Schaltbauelement nach einem der Ansprüche 1 bis 5, **dadurch gekennzeichnet, dass** der Betrieb des heißen Transistors (TEC1) im Verstärkungszustand für an das Gate G angelegte Vorspannungen (Ha) zwischen -0,4 Volt and 0 Volt erhalten wird, wobei der Sperrzustand für an das Gate G angelegte Spannungen (Ba) zwischen -1,5 Volt und -0,8 Volt erzielt wird.

7. Schaltbauelement nach einem der Ansprüche 1 bis 6, **dadurch gekennzeichnet, dass** für kalte Feldeffekttransistoren (TEC2, TEC3), die als passive, serielle oder parallele Schalter arbeiten, der Durchlasszustand des kalten Transistors (TEC2, TEC3) für Gate-Spannungen (Vg) zwischen + 0,3 Volt und 0,6 Volt erzielt wird, wobei der Sperrzustand des kalten Transistors (TEC2, TEC3) für Gate-Spannungen (Vg) zwischen -2 Volt und - 2,5 Volt erzielt wird.

8. Schaltbauelement nach einem der Ansprüche 1 bis 7, **dadurch gekennzeichnet, dass** das aktive Schaltelement einen Signaleingang Ea, einen verstärkten Signalausgang Sa und einen Vorspannungseingang Pa des Transistors des aktiven Schaltelements (TEC1) umfasst.

9. Schaltbauelement nach einem der Ansprüche 1 bis 8, **dadurch gekennzeichnet, dass** das passive Schaltelement einen Signaleingang Ep, einen Signalausgang Sp und einen Vorspannungseingang Pp des Transistors des passiven Schaltelements (TEC2, TEC3) umfasst.

10. Integrierte Hyperfrequenzschaltung für eine Antenne mit elektronischer Strahlschwenkung, umfassend einen gemeinsamen Modulationskanal (22, 66) mit einem Eingang (Evc) und einem Ausgang (Svc), wobei die integrierte Schaltung ferner einen bidirektionalen Zugriffsanschluss ER, einen Empfangseingang E für ein von einer Antenne empfangenes Signal und einen Ausgang S umfasst, der ein Sendesignal an die Antenne anlegt, **dadurch gekennzeichnet, dass** sie ein Schaltbauelement nach einem der vorherigen Ansprüche zum Schalten des gemeinsamen Modulationskanals (60) entweder zwischen dem bidirektionalen Zugriffsanschluss ER und dem Empfangseingang E oder zwischen dem bidirektionalen Zugriffsanschluss ER und dem Sendeausgang S der integrierten Schaltung umfasst.

11. Integrierte Hyperfrequenzschaltung nach Anspruch 10, **dadurch gekennzeichnet, dass** sie Folgendes umfasst:
- ein aktives Schaltelement (70) in Serie mit einem passiven Schaltelement (72) zwischen dem Empfangseingang E der Schaltung und dem Eingang Evc des gemeinsamen Modulationskanals (60), wobei der Eingang Ea des aktiven Elements (70) mit dem Empfangseingang E der integrierten Schaltung verbunden ist,
- vier Schaltelemente in Kaskade zwischen dem bidirektionalen Zugriffsanschluss ER und dem Eingang Evc des gemeinsamen Modulationskanals (60), ein erstes passives Schaltelement (74) in Serie mit einem aktiven Schaltelement (76), wobei der Eingang Ea des aktiven Schaltelements (76) mit dem bidirektionalen Eingang ER der Schaltung durch das erste passive Element (74) verbunden ist, wobei ein zweites passives Schaltelement (78) parallel zwischen dem Ausgang Sa des aktiven Schaltelements (76) und einem Bezugspotential (M) verbunden ist, wobei ein drittes passives Element (80) parallel zwischen dem Ausgang Sa des aktiven Schaltelements (76) mittels einer ersten Viertelwellenleitung (82) und dem Bezungspotential verbunden ist, wobei eine zweite Viertelwellenleitung (84) den gemeinsamen Punkt zwischen dem dritten passiven Element (80) und der ersten Viertelwellenleitung (82) mit dem Eingang Evc des gemeinsamen Modulationskanals (60) verbindet,
- zwei Schaltelemente in Kaskade zwischen dem Ausgang Svc des gemeinsamen Modulationskanals (60) und dem Sendeausgang S der Schaltung, ein passives Schaltelement (90) in Serie mit einem aktiven Schaltelement (92), wobei der Ausgang Sa des aktiven Schaltelements (92) mit dem Sendeausgang S der integrierten Schaltung verbunden ist, und
- eine erste (96) und eine zweite (98) Viertelwellenleitung, die in Serie mit dem Eingang Ea eines aktiven Schaltelements (100) geschaltet sind, zwischen dem Ausgang Svc des gemeinsamen Modulationskanals (60) und dem bidirektionalen Zugriffsanschluss ER des Moduls aus vier Schaltelementen in Kaskade, wobei der Ausgang Sa des aktiven Schaltelements (100) mit dem bidirektionalen Ausgang ER durch ein erstes passives Schaltelement (102) in Serie geschaltet ist, wobei ein zweites passives Schaltelement (104) parallel zwischen dem gemeinsamen Punkt der ersten (96) und der zweiten (98) seriellen Viertelwellenleitung und dem Bezugspotential (M) geschaltet ist, wobei ein drittes passives Schaltelement (106) parallel zwischen dem gemeinsamen Punkt der zweiten Viertelwellenleitung (98) und dem Eingang Ea des aktiven Schaltelements (100) und dem Bezugspotential (M) geschaltet ist.

12. Integrierte Hyperfrequenzschaltung nach Anspruch 10 oder 11, **dadurch gekennzeichnet, dass** in einer "alle aus"-Modus-Konfiguration die aktiven Elemente (70, 76, 92, 100) der integrierten Schaltung im Sperrzustand sind, die passiven Serienelemente (72, 74, 90, 102) im Sperrzustand (Unterbrecher offen) und die parallelen passiven Elemente (78, 80, 104, 106) im Durchlasszustand (Unterbrecher geschlossen) sind.

13. Integrierte Hyperfrequenzschaltung nach einem der Ansprüche 10 bis 12, **dadurch gekennzeichnet, dass** sie eine MC-Steuerschaltung (110) umfasst, die die Vorspannungen der Schaltelemente bereitstellt:
- eine Vorspannung (Vga) für die aktiven Schaltelemente (70, 76, 92, 100), die entweder einen ersten Wert Ha annehmen kann, der das aktive Schaltelement in den Verstärkungszustand versetzt, oder einen zweiten Wert Ba, der das aktive Schaltelement in den Sperrzustand versetzt,
- eine andere Vorspannung (Vgp) für die passiven Schaltelemente (72, 74, 78, 80, 90, 102, 104, 106), die entweder einen ersten Wert Hp, der das passive Schaltelement in den Durchlasszustand versetzt, oder einen zweiten Wert Bp annehmen können, der das passive Schaltelement in den Sperrzustand versetzt.
